# EUROPÄISCHE PATENTSCHRIFT

(11) **EP 1 586 127 B1**
(45) Veröffentlichungstag und Bekanntmachung des Hinweises auf die Patenterteilung: **02.05.2007**
(21) Anmeldenummer: 04701943.5
(22) Anmeldetag: 14.01.2004
(51) Int. Cl.: H01L 51/52

(54) **ORGANISCHES ELEKTRONIKBAUTEIL UND VERFAHREN ZUR HERSTELLUNG ORGANISCHER ELEKTRONIK**
ORGANIC ELECTRONIC COMPONENT AND METHOD FOR PRODUCING ORGANIC ELECTRONIC DEVICES
COMPOSANT ELECTRONIQUE ORGANIQUE ET PROCEDE DE FABRICATION DE DISPOSITIFS ELECTRONIQUES ORGANIQUES

(30) Priorität: 21.01.2003 DE 10302146
(43) Veröffentlichungstag der Anmeldung: 19.10.2005
(73) Patentinhaber: PolyIC GmbH & Co. KG, 90763 Fürth (DE)
(72) Erfinder: BERNDS, Adolf, 91083 Baiersdorf (DE); KNOBLOCH, Alexander, Friedrich, 91233 Neunkirchen (DE); MANUELLI, Alessandro, 91052 Erlangen (DE)
(74) Vertreter: Zinsinger, Norbert
(86) Internationale Anmeldenummer: PCT/EP2004/000216
(87) Internationale Veröffentlichungsnummer: WO 2004/066348

(56) Entgegenhaltungen:
- WO-A-02/05360
- WO-A-02/05361
- WO-A-02/099908
- ROGERS J A ET AL: "PRINTING PROCESS SUITABLE FOR REEL-TO-REEL PRODUCTION OF HIGH-PERFORMANCE ORGANIC TRANSISTORS AND CIRCUITS" ADVANCED MATERIALS, VCH VERLAGSGESELLSCHAFT, WEINHEIM, DE, Bd. 11, Nr. 9, 5. Juli 1999 (1999-07-05), Seiten 741-745, XP000851834 ISSN: 0935-9648

## Beschreibung

Die Erfindung betrifft ein organisches elektronisches Bauteil und ein Verfahren zur kostengünstigen und massenfertigungstauglichen Herstellung organischer Elektronik.

Bekannt ist die Herstellung organischer Bauteile durch eine Kombination kontinuierlicher und diskontinuierlicher Verfahren. So werden beispielsweise die nicht strukturierten Schichten durch diskontinuierliche Beschichtungsprozesse wie Spin Coating (wobei jeweils einzelne Scheiben beschichtet werden) hergestellt und strukturierte Schichten durch Bedrucken oder ähnliches im kontinuierlichen Rolle-zu-Rolle Verfahren (z.B. DE 10033112.2, WO 02/099908).

Bislang galt es als unwahrscheinlich, dass sich ein organisches elektronisches Bauteil komplett im kontinuierlichen Verfahren herstellen lässt, weil die gängigen Beschichtungstechniken, allen voran Spin Coating, nicht rollenkompatibel ist.

Aufgabe der vorliegenden Erfindung ist es, ein Verfahren zu schaffen, mit dem der Aufbau eines organischen elektronischen Bauteils im Rolle-zu-Rolle Verfahren hergestellt werden kann. Ebenso ist es Aufgabe der vorliegenden Erfindung ein organisches elektronisches Bauteil zur Verfügung zu stellen, das in Massenfertigung kontinuierlich herstellbar ist.

Gegenstand der Erfindung ist daher ein Verfahren zur Herstellung eines organischen elektronischen Bauteils, das kontinuierlich oder zumindest quasi kontinuierlich geführt wird. Insbesondere ist Gegenstand der Erfindung ein Verfahren zur Herstellung eines organischen elektronischen Bauteils, das komplett im Rolle-zu-Rolle Verfahren ausgeführt wird. Außerdem ist Gegenstand der Erfindung ein organisches elektronisches Bauteil, das in einem kontinuierlichen oder zumindest quasi kontinuierlichen Massenfertigungsprozess herstellbar ist.

Insbesondere ist Gegenstand der Erfindung ein Verfahren zur kontinuierlichen oder zumindest quasi kontinuierlichen Herstellung des organischen Bauteils folgende Produktionsschritte umfassend:
- auf einem Substrat, das ein durchgehendes Band, zusammenhängend (web feed) oder aneinandergereihte einzelne Bögen(sheet feed), bildet, wird über eine kontinuierliche Beschichtungsmethode ein funktionales organisches Material (leitend, halbleitend oder isolierend) aufgetragen,
- auf diese funktionale Schicht wird strukturiert ein Lack aufgedruckt,
durch diesen Lack wird die funktionale Schicht, eventuell über weitere Prozessschritte, strukturiert.

Ausgestaltungen der Erfindung ergeben sich aus den Ansprüchen, den Figuren und der Beschreibung.

Als organisches elektronisches Bauteil wird ein organischer Feld-Effekt-Transistor (OFET), ein organisches photovoltaisches Element, eine organische Diode, insbesondere eine organische Leuchtdiode (OLED), oder ein sonstiges elektronisches Bauteil bezeichnet, das zumindest eine organische Funktionsschicht wie die halbleitende Schicht oder die leitende Schicht umfasst.

Nach einer Ausführungsform des Verfahrens zur kontinuierlichen Herstellung des organischen Bauteils sind folgende Produktionsschritte umfasst:
- auf einem Substrat, das ein durchgehendes Band, das beispielsweise ein zusammenhängendes Band sein kann (web feed) oder aneinandergereihte einzelne Bögen (sheet feed), bildet, wird über eine kontinuierliche Beschichtungsmethode ein funktionales organisches Material (leitend) aufgetragen,
- auf diese funktionale Schicht wird strukturiert ein Lack aufgedruckt,
- durch diesen Lack wird die leitfähige Schicht strukturiert,
- auf die so gebildeten Leiterbahnen oder Elektroden wird über eine kontinuierliche Beschichtungsmethode eine halbleitende Schicht aufgetragen,
- auf die halbleitende Schicht wird ebenfalls über eine kontinuierliche Beschichtungsmethode eine Isolatorschicht aufgetragen und
- auf die Isolatorschicht wird eine obere Elektrode aufgedruckt.

Als kontinuierliche Beschichtungsmethode werden beispielsweise die vorgeschlagen, die in "Coatings Technology Handbook" 2^{nd} Edition Herausgeber: D. Satas und Arthur A. Tracton Verlag Marcel Dekker New York Basel, Kapitel 18 "Porous Roll Coater" Seiten 165 bis 178 und "Modern Coating and Drying Technology" Herausgeber: Edward D. Cohen und Edgar B. Gutoff Wiley-Verlag Weinheim, Seiten 1 bis 10 beschrieben werden. Überraschend ist, dass die dort aufgeführten Verfahren rollenkompatibel zum Aufbau organischer Elektronik einsetzbar sind, so dass homogene Polymerschichten für den Aufbau von organischer Elektronik resultieren.

Es handelt sich hierbei um rollenkompatible Beschichtungstechniken. Folgende Beispiele fassen kurz zusammen, welche Techniken hierbei besonders vorteilhaft erscheinen:

Das Porous Roll Coating hat eine Entsprechung im Siebdruck, nur dass anstelle einer Siebrolle ein poröser Zylinder verwendet wird. Die Beschichtungsflüssigkeit dringt vom Inneren des Zylinders durch die Poren entweder auf eine weitere Rolle und von dort auf das zu beschichtende Band oder direkt auf das Band. Der Vorteil gegenüber dem Siebdruck besteht darin, dass die Poren wesentlich feiner ausführbar sind als die Öffnungen im Sieb, somit kann mit sehr viel niederviskoseren (dünneren) Flüssigkeiten gearbeitet werden. Das Porous Roll Coating ist eines der wenigen Verfahren (außerdem nur noch das Gravure Coating), dass auch einen strukturierten Auftrag (direkte Strukturierung) erlaubt, indem die Poren lokal verschlossen werden, d.h. es eignet sich sowohl zum Beschichten als auch zum Drucken.

Dip Coating, wobei ein kontinuierliches Band durch zumindest eine Flüssigkeit gezogen wird, Rod Coating, bei dem ein Band tangentiell an einer Rolle oder Walze vorbeigezogen wird, die noch mit einer Flüssigkeit benetzt ist, Blade Coating, bei dem ein Band an einer Walze anliegt, die an einem mit Flüssigkeit gefüllten Behältnis vorbeiführt, wobei das Behältnis an zwei Seiten geschlossen ist, an einer dritten Seite durch die Walze und an einer vierten Seite durch ein Rakel begrenzt wird, das in einem Abstand über dem Band anliegt, so dass die Flüssigkeit in dem Abstand in dem Behältnis zurückgehalten wird und nicht auf dem Band haftet in dem sich das Rakel über dem Band befindet.

Ein weiteres rollenkompatibles Beschichtungs- oder Coating-Verfahren ist das air knife coating, das dem Dip Coating gleich ist bis auf ein Gebläse, durch das die Flüssigkeit auf dem durch die Flüssigkeit gezogene Band an einer Stelle getrocknet und/oder weggeblasen wird. Diese vier Coating Prozesse sind bereits zur Herstellung anderer Polymerschichten bekannt und in dem eingangs zitierten Text beschrieben und durch Zeichnungen erläutert. Weitere rollenkompatible Beschichtungsverfahren sind Gravure Coating, bei dem zwei nicht gleich große Walzen (oder Rollen) in der gleichen Richtung betrieben werden und aneinandergrenzen, wobei die größere Walze durch eine Flüssigkeit geführt wird und an der kleineren Walze das Band anliegt, wobei die Dicke der Benetzung, mit der die größere Walze an die kleinere anschließt, durch ein Rakel, das an der größeren befestigt ist, begrenzt ist, ein weiteres Verfahren ist das reverse roll coating, bei dem zwei gegenläufig sich bewegende Walzen aneinander gedrückt werden, wobei die eine Walze mit Flüssigkeit benetzt ist und entlang der anderen Walze das kontinuierliche Band geführt wird. Schließlich sind noch die dort beschriebenen Techniken des Forward Roll Coatings, des Slot und Extrusion coatings, des Slide Coatings, des Curtain Coatings besonders vorteilhaft, wobei aus der Reihenfolge in der sie beschrieben und/oder benannt wurde keine Wertung herausgelesen werden sollte. Schließlich gibt es noch das Spraying Coating, das vor dem Hintergrund, dass Spraying "sprühen" heißt, selbst erklärend ist.

Der Vorteil der Beschichtungstechniken allgemein für die organische Elektronik ist der, dass damit dünne homogene Schichten (Dicke etwa 0.02 bis 2.0µm) kontinuierlich herstellbar sind. Da die Beschichtungstechniken selbst nicht strukturgebend sind, können sie nur in Kombination mit strukturgebenden Verfahren, wie den Drucktechniken, eingesetzt werden. Durch Kombination von rollenkompatiblen Beschichtungstechniken mit Rolle-zu-Rolle Druckverfahren kann man sämtliche Produktionsschritte eines organischen elektronischen Bauteils rollenkompatibel machen.

Als Rolle-zu-Rolle Verfahren wird ein Verfahren bezeichnet, das kontinuierlich ist, also als Bandware in dem oben erwähnten Sinn, also sowohl web feed als auch sheet feed, produziert werden kann und in dem im wesentlichen Walzen zur Beschichtung, zum Bedrucken und/oder zu sonstigen Verarbeitungsschritten eingesetzt werden.

Als Aufbau eines organischen elektronischen Bauteils werden die Grundelemente eines organischen elektronischen Bauteils bezeichnet, Substrat als Bandware in dem oben erwähnten Sinn, also sowohl web feed als auch sheet feed, die den Träger bildet, darauf eine untere Elektrode, eine halbleitende, photovoltaisch aktive und/oder emittierende Schicht, isolierende Schicht(en) und obere Elektrode.

Unter "Massenfertigung" wird eine Produktion verstanden, die die Herstellung von low-cost Produkten wie Einwegchips durch einfache Produktionsschritte mit hoher Durchsatzquote, also hohe Stückzahl pro Zeiteinheit und optimale Auslastung der Maschinen, Vermeidung von Verweilzeiten in Maschinen etc. erlaubt und/oder erst ermöglicht.

Als "kontinuierliches" Verfahren wird eine Produktion bezeichnet, durch die nicht "Stück für Stück" verarbeitet wird, sondern "am laufenden Meter" wie die Produktion an einem durchgehenden Band. Im diskontinuierlichen Verfahren, also der Produktion "Stück für Stück" wird für eine low cost Produktion zuviel Zeit durch einlegen und ausladen des gerade produzierten Stückes in die Maschine und aus der Maschine wieder heraus. Die Vorteile des Fließbandes sind die, die mit dem Term "kontinuierliches Verfahren" hier gemeint sind. Ein quasi kontinuierliches Verfahren kann dabei kleinere Stops in der Produktionskette umfassen, verfügt aber zumindest über zwei aneinanderhängende kontinuierlich verlaufende Produktionsschritte.

Nach einer Ausführungsform ist das organische elektronische Bauteil ein Feld-Effekt-Transistor, zumindest ein Substrat, eine untere, Source und Drain umfassende Elektrode, eine halbleitende Schicht, eine isolierende Schicht und eine obere Elektrode umfassend.

Als "indirekte Strukturierung" wird die Art der Strukturierung bezeichnet, bei der zunächst eine eigens zur Strukturierung einer unteren Schicht aufgebrachte Schicht (Lackschicht etc.) strukturiert wird. Eine "direkte Strukturierung" ist entsprechend eine unmittelbare Strukturierung einer Schicht.

Nach einer Ausführungsform des Verfahren finden vor den jeweiligen Beschichtungs- und Bedruckungsverfahren Vorbehandlungsverfahren statt, beispielsweise zur Reinigung und/oder Vorbehandlung der Oberfläche, z.B. Corona-, Flammen-, UV-, Plasmabehandlung und/oder sonstige Verfahren.

Nach einer weiteren Ausführungsform des Verfahrens findet nach dem jeweiligen Beschichtungs- und/oder Bedruckungsverfahren zumindest ein Trocknungs- oder Härtungsprozess statt, z.B. mit Wärme, UV-Licht, Infrarotlicht und/oder sonstigen Verfahren.

Im folgenden wird die Erfindung noch anhand der beispielhaften Herstellung eines organischen Feld-Effekt-Transistors näher erläutert.

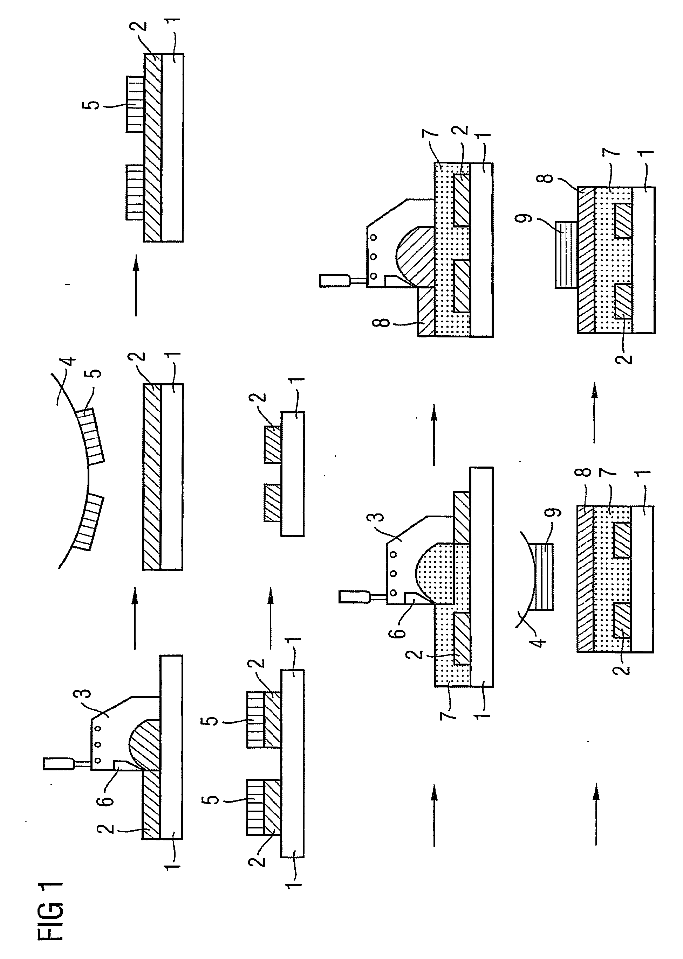

Die Figur zeigt die Verfahrensschritte zur Herstellung der unteren Elektrode(n) 2, der halbleitenden Schicht 7, der Isolatorschicht 8 und der oberen Elektrode 9 auf einem Substrat 1: Zu sehen ist das Band 1, das das Substrat bildet, darauf wird über eine kontinuierliche Beschichtungsmethode ein funktionales organisches Material, insbesondere ein leitfähiges Polymer, 2 aufgebracht. Das organische Funktionsmaterial kann in einem oder mehreren organischen oder anorganischen Lösungsmitteln gelöst oder dispergiert sein, als reines Material vorliegen, als Mischung und/oder mit Additiven versehen.

Die kontinuierliche Beschichtungsmethode umfasst ein Rakel 6 das in eine Maschine 3 integriert ist. Auf die Beschichtung 2 wird über eine Walze 4 ein Lack 5 strukturiert aufgebracht, mit dessen Hilfe die untere(n) Elektrode(n) 2 strukturiert wird. Auf die strukturierte(n) untere(n) Elektrode(n) 2 wird eine halbleitende Schicht 7 wieder unter Einsatz einer mit einem Rakel 6 ausgestatteten Maschine 3 aufgebracht. Auf diese Schicht legt man eine Isolatorschicht 8 wieder mit einer Beschichtungstechnik auf die schließlich strukturiert eine obere Elektrode 9 aufgebracht wird (direkte Strukturierung). Die Maschine 3 ist vorzugsweise zum Dip Coating, Rod Coating, Knife Coating, Blade Coating, Air Knife Coating, Gravure Coating, Forward und Reverse Roll Coating, Slot und Extrusion Coating, Slide Coating, Curtain Coating und/oder Spraying Coating mit einer Walze kombiniert, wie in der oben zitierten Literatur und in der Beschreibung bereits erwähnt. Beim Blade Coating wird, wie aus der schematischen Figur ersichtlich, eine planare Schicht angewendet.

Durch das erfindungsgemäße Verfahren wird erstmals eine Möglichkeit aufgezeigt, mit der eine kontinuierliche Rolle-zu-Rolle Beschichtung für die kostengünstige Massenproduktion organischer elektronischer Bauteile durchführbar ist. Bisher waren nur kontinuierliche Verfahren bekannt, die sich der Drucktechniken bedienen, wobei das Problem ist, dass mit keiner Drucktechnik dünne Schichten mit für die organische Elektronik ausreichender Homogenität erzeugbar sind.

Mit Hilfe der Erfindung können alle Arten organischer elektronischer Bauteile in einem kontinuierlichen Massenfertigungsprozess hergestellt werden. Dazu gehören z.B. organische Transistoren und Schaltungen hieraus, organische Dioden, organisch basierte Kondensatoren, organische Photovoltaik-Zellen, organische Sensoren und Aktoren, sowie Kombinationen hieraus.

## Patentansprüche

1. Verfahren zur Herstellung eines organischen elektronischen Bauteils, wobei mindestens eine funktionelle organisch basierte Schicht des Bauteils durch einen kontinuierlichen Verfahrensschritt als homogene unstrukturierte Schicht in einem rollenkompatiblen Verfahren gewählt aus der Gruppe umfassend Porous Roll Coating, Dip Coating, Rod Coating, Knife Coating, Blade Coating, Air Knife Coating, Gravure Coating, Forward und Reverse Coating, Slot und Extrusion Coating, Slide Coating, Curtain Coating und Spraying auf ein Substrat aufgebracht wird, wobei das Substrat während des Aufbringens der fünktionellen, organisch basierten Schicht von Rolle zu Rolle transportiert wird, wobei vor dem kontinuierlichen Verfahrensschritt eine Reinigung und/oder Vorbehandlung der mit dieser Schicht zu beschichtenden Oberfläche des Substrats erfolgt, und wobei die mindestens eine funktionelle organisch basierte Schicht des Bauteils in einem nachfolgenden Verfahrensschritt direkt oder indirekt strukturiert wird.

2. Verfahren nach Anspruch 1, wobei das organische elektronische Bauteil komplett im Rolle-zu-Rolle-Verfahren auf dem Substrat, das als durchgehendes Band oder aus aneinander gereihten einzelnen Bögen gebildet ist, ausgeführt wird.

3. Verfahren nach einem der vorstehenden Ansprüche, wobei das elektronische Bauteil aus mehreren Einzelschichten, umfassend die mindestens eine funktionelle organisch basierte Schicht, aufgebaut wird.

4. Verfahren nach einem der Ansprüche 1 bis 3, wobei
- auf dem Substrat, das ein durchgehendes Band bildet, welches zusammenhängend (web feed) ausgebildet ist oder durch aneinander gereihte einzelne Bögen (sheet feed) gebildet ist, über den kontinuierlichen Verfahrensschritt zur Bildung der fünktionellen, organisch basierten Schicht ein funktionales organisches Material (leitend, halbleitend oder isolierend) homogen und unstrukturiert aufgetragen wird,
- auf diese Schicht strukturiert ein Lack aufgedruckt wird,
- durch diesen Lack diese Schicht direkt oder über weitere Prozessschritte strukturiert wird.

5. Verfahren nach Anspruch 4, wobei vor dem Bedrucken mit Lack zumindest ein Vorbehandlungsschritt stattfindet.

6. Verfahren nach einem der vorstehenden Ansprüche, wobei nach dem kontinuierlichen Verfahrensschritt und/oder dem Strukturieren eine Nachbehandlung der strukturierten Schicht mittels Trocknen und/oder Härten durchgeführt wird.

7. Verfahren nach einem der vorstehenden Ansprüche, bei dem die Strukturierung der Schicht(en) des Bauteils in einem rollenkompatiblen Verfahren durchgeführt wird, welches aus der Gruppe umfassend Tiefdruck, Flachdruck (Offset), Hochdruck (Flexo), Tintenstrahl, Laserdruck, sowie Kombinationen dieser und/oder verwandter Verfahren gewählt wird.

8. Verwendung eines Verfahrens nach einem der Ansprüche 1 bis 7 zur Herstellung eines organischen elektronischen Bauteils aus der Gruppe organischer Feld-Effekt-Transistoren (OFET), organischer photovoltaischer Elemente, organischer Dioden und organischer Leuchtdioden (OLED).

## Claims

1. Method for the manufacture of an organic electronic component, wherein at least one functional organically-based layer of the component is applied onto a substrate by means of a continuous method step as a homogenous unstructured layer in a rolling-compatible method selected from the group comprising porous roll coating, dip coating, rod coating, knife coating, blade coating, air knife coating, gravure coating, forward and reverse coating, slot and extrusion coating, slide coating, curtain coating and spraying, wherein the substrate is conveyed from roll to roll during the application of the functional organically-based layer, wherein before the continuous method step cleaning and/or pre-treatment takes place of the surface of the substrate to be coated with this layer, and wherein the minimum of one functional organically-based layer of the component is structured directly or indirectly in a subsequent method step.

2. Method according to Claim 1, wherein the organic electronic component is formed complete in the roll-to-roll method on the substrate, which is formed as a continuous strip or from individual sheets arranged next to one another.

3. Method according to any one of the preceding claims, wherein the electronic component is formed from a plurality of individual layers, comprising the minimum of one functional organically-based layer.

4. Method according to any one of Claims 1 to 3, wherein
- on the substrate, which forms a continuous strip, which is designed as cohesive (web feed), or by individual sheets arranged next to one another (sheet feed), by way of the continuous method step to form the functional organically-based layer, a functional organically-based material (conductive, semiconductive, or insulating) is applied in a homogenous and unstructured manner,
- a lacquer is printed in a structured manner onto this layer,
- by way of this lacquer this layer is structured directly or by further process steps.

5. Method according to Claim 4, wherein at least one pre-treatment stage takes place before the printing with lacquer.

6. Method according to any one of the preceding claims, wherein, after the continuous method step and/or the structuring, a secondary treatment of the structured layer is carried out by means of drying and/or hardening.

7. Method according to any one of the preceding claims, wherein the structuring of the layer(s) of the component is carried out in a roll-compatible method, which is selected from the group comprising gravure printing, offset, flexo, ink-jet, laser printing, and combinations of these and/or associated methods.

8. Use of a method according to any one of Claims 1 to 7, for the manufacture of an organic electronic component from the group of organic field-effect transistors (OFET), organic photovoltaic elements, organic diodes, and organic light-emitting diodes (OLED).

## Revendications

1. Procédé de fabrication d'un composant électronique organique, dans lequel au moins une couche fonctionnelle du composant à base organique est appliquée sur un substrat comme couche homogène non structurée par une étape de procédé continue dans un procédé compatible à rouleaux, choisi parmi le groupe comprenant Porous Roll Coating, Dip Coating, Rod Coating, Knife Coating, Blade Coating, Air Knife Coating, Gravure Coating, Forward et Reverse Coating, Slot et Extrusion Coating, Slide Coating, Curtain Coating et Spraying, sachant que, pendant l'application de la couche fonctionnelle à base organique, le substrat est transporté de rouleau à rouleau, lors de quoi une purification et/ou un pré-traitement de la surface à revêtir de cette couche du substrat s'effectuent avant l'étape continue de procédé, et lors de quoi ladite au moins une couche fonctionnelle à base organique du composant est structurée directement ou indirectement dans une étape de procédé suivante.

2. Procédé selon la revendication 1, dans lequel le composant électronique organique est exécuté complètement dans le procédé rouleau à rouleau, sur le substrat qui est configuré comme ruban continu ou en feuilles séparées rangées l'une à côté de l'autre.

3. Procédé selon l'une quelconque des revendications précédentes, dans lequel le composant électronique est constitué de plusieurs couches individuelles, comprenant ladite au moins une couche fonctionnelle à base organique.

4. Procédé selon l'une quelconque des revendications 1 à 3, dans lequel
- sur le substrat qui forme une bande ininterrompue, laquelle est configurée solidaire (web feed) ou est formée de feuilles individuelles rangées l'une à côté de l'autre, un matériau organique fonctionnel (conducteur, semi-conducteur ou isolant) est appliqué de façon homogène et non structurée par l'étape de procédé continue pour la formation de la couche fonctionnelle à base organique,
- sur cette couche, une laque est imprimée de façon structurée,
- par cette laque, cette couche est structurée directement ou par l'intermédiaire d'autres étapes de processus.

5. Procédé selon la revendication 4, dans lequel au moins une étape de pré-traitement a lieu avant l'impression avec la laque.

6. Procédé selon l'une quelconque des revendications précédentes, dans lequel, après l'étape de procédé continue et/ou la structuration, un traitement ultérieur de la couche structurée est effectué par séchage et/ou par durcissement.

7. Procédé selon l'une quelconque des revendications précédentes, dans lequel la structuration de la ou des couches du composant est effectuée dans un procédé compatible à des rouleaux, lequel est choisi parmi le groupe comprenant l'héliogravure, l'impression à plat (offset), l'impression en relief (flexo), le jet d'encre, l'impression laser, ainsi que des combinaisons de ces procédés et/ou de procédés apparentés.

8. Utilisation d'un procédé selon l'une quelconque des revendications 1 à 7 à la fabrication d'un composant électronique organique parmi le groupe des transistors à effet de champ organiques (OFET), des éléments photovoltaïques organiques, des diodes organiques et des diodes électroluminescentes organiques (OLED).
